# EUROPEAN PATENT APPLICATION

(11) **EP 4 415 492 A1**
(43) Date of publication of application: **14.08.2024**
(21) Application number: 22889241.0
(22) Date of filing: 31.10.2022
(51) Int. Cl.: H05K 5/02

(54) **DAMPING PIN AND CABINET**

(30) Priority: 03.11.2021 CN 202122676169 U
(71) Applicant: Huawei Technologies Co., Ltd., Shenzhen, Guangdong 518129 (CN)
(72) Inventor: CHEN, Wei, Shenzhen, Guangdong 518129 (CN); TIAN, Guoqing, Shenzhen, Guangdong 518129 (CN)
(74) Representative: Thun, Clemens
(86) International application number: PCT/CN2022/128729
(87) International publication number: WO 2023/078216

(57) **Abstract**

Embodiments of this application provide a damping pin and a cabinet. The damping pin includes a male shaft and a female shaft. The male shaft includes: a large head end and a pin connected to an end face of an end of the large head end. The female shaft has a jack. The pin is rotatably disposed in the jack, and at least a part of an outer side wall of the pin is in an interference fit with an inner side wall of the jack. The damping pin and the cabinet provided in embodiments of this application may effectively reduce a quantity of components of a rotating connection mechanism in a conventional technology, reduce assembly workload, and improve assembly efficiency. In addition, an assembly span and a damping force are more flexible, facilitating unification of product specifications.

## Description

This application claims priority to Chinese Patent Application No. 202122676169.7, filed with the China National Intellectual Property Administration on November 3, 2021 and entitled "DAMPING PIN AND CABINET", which is incorporated herein by reference in its entirety.

### TECHNICAL FIELD

Embodiments of this application relate to the field of mechanical connection structure technologies, and in particular, to a damping pin and a cabinet.

### BACKGROUND

In a communication relay link of an existing network, especially at a node that is close to a terminal, a structure such as a small cabinet, a module, or the like is used as a carrier. For use and maintenance requirements, there is a structure such as a door plate or a cover plate in this type of structure. The door plate or the cover plate is rotatably opened to expose an internal line structure of a cavity, facilitating onsite operation and maintenance. Most of these nodes are mounted outdoors or at high altitudes. Considering a weight of the door plate or the cover plate and a strong wind that often occurs during outdoor operation, and that an operation process is usually performed by a single person, for convenience of maintenance and safety of an operator, the door plate or the cover plate needs to remain unchanged in a position when being opened. Therefore, a corresponding rotating connection mechanism needs a static friction force, that is, damping.

In a conventional technology, a rotating connection mechanism between the door plate, the cover plate, and the like, and the small cabinet, the module, and the like generally adopts a hinge structure. In a solution, a hinge includes a bottom plate, a first vertical plate, a second vertical plate, and a pivot shaft. The first vertical plate and the second vertical plate are disposed at two ends of the bottom plate. The first vertical plate and the second vertical plate are separately integrally molded with the bottom plate. The first vertical plate is provided with a first through hole, and the second vertical plate is provided with a second through hole. The first through hole is provided with a first side shaft, and the second through hole is provided with a second side shaft. An end of the pivot shaft is inserted into the first side shaft, and the other end of the pivot shaft is inserted into the second side shaft. The bottom plate is provided with a first positioning hole, and the pivot shaft is provided with a second positioning hole. The hinge may be connected to an object by using a screw through the first positioning hole, and a door plate may be connected to the hinge by using a screw through the second positioning hole.

However, the foregoing hinge structure features a large quantity of parts, low assembly efficiency, and high costs. In addition, the hinge structure is only appropriate for span-fixed-distance assembly. When a span changes, a hinge of different specifications is required, and therefore product specifications are less unified.

### SUMMARY

Embodiments of this application provide a damping pin and a cabinet, to effectively reduce a quantity of components of a rotating connection mechanism in a conventional technology, reduce assembly workload, and improve assembly efficiency. In addition, an assembly span and a damping force are more flexible, facilitating unification of product specifications.

To achieve the foregoing objective, one aspect of embodiments of this application provides a damping pin, including a male shaft and a female shaft, where
the male shaft includes: a large head end and a pin connected to an end face of an end of the large head end; and
the female shaft has a jack, the pin is rotatably disposed in the jack, and at least a part of an outer side wall of the pin is in an interference fit with an inner side wall of the jack.

The damping pin provided in embodiments of this application includes two core components: the male shaft and the female shaft. Compared with a rotating connection mechanism in a conventional technology, a quantity of parts is greatly reduced. In addition, the damping pin provided in embodiments of this application relates to a cold heading process and a finish machining process, and there are few machining processes and machining operations. In addition, when the damping pin provided in embodiments of this application is connected to a component, a few assembly parts are used, or even no assembly part is required. In conclusion, the damping pin provided in embodiments of this application may effectively reduce a quantity of parts and a quantity of assembly parts, reduce assembly workload and assembly space, improve assembly efficiency, and reduce costs. Furthermore, the damping pin provided in embodiments of this application is small in size. When a span of a rotating connection part changes, one, two, or more damping pins may be disposed based on a specific working condition, without changing specifications of the damping pins, facilitating unification of product specifications. In addition, the damping pin provided in embodiments of this application is further editable in terms of a damping force. Generally, the damping pins are used in pairs. When the span of the rotating connection part is large, one or more damping pins may be added between two damping pins. Damping forces of a plurality of damping pins may be different. During assembly, different damping effect may be implemented through permutations and combinations of the damping pins.

In a possible implementation, the inner side wall of the jack has a first limiting boss; and
the first limiting boss is clamped with the pin to limit displacement of the pin in an axial direction of the jack.

In a possible implementation, an end that is of the pin and that is away from the large head end has a blind hole; and
an outer side wall of the blind hole is enabled, by the blind hole through a spin riveting swaging process, to clamp with the first limiting boss.

In a possible implementation, the damping pin further includes an annular spring plate, where
the annular spring plate is sleeved on the outer side wall of the blind hole, and an outer peripheral wall of the annular spring plate is in an interference fit with the inner side wall of the jack.

In a possible implementation, the damping pin further includes a sealing cover, where
the sealing cover caps an end that is of the jack and that is away from the large head end.

In a possible implementation, a groove is provided on the outer side wall of the pin; and the groove is configured to store an auxiliary medium.

In a possible implementation, an end that is of the large head end and that is away from the pin is in a shape of a guide curved surface.

In a possible implementation, a second limiting boss is disposed on an outer side wall that is of the female shaft and that is away from the large head end.

In a possible implementation, both the end that is of the large head end and that is away from the pin and an end that is of the female shaft and that is away from the large head end are in shapes of guide curved surfaces.

In a possible implementation, knurling patterns are provided on an outer peripheral surface of the large head end and an outer peripheral surface of the female shaft.

Another aspect of embodiments of this application provides a cabinet, including: a housing, a cover plate that is rotatably disposed with the housing, and at least one damping pin described above, where
the housing has a first mounting base, and the cover plate has a second mounting base; and
one of the large head end of the damping pin and the female shaft of the damping pin is fastened in the first mounting base, and the other of the large head end of the damping pin and the female shaft of the damping pin is fastened in the second mounting base.

The cabinet provided in embodiments of this application includes the damping pin, and the damping pin includes two core components: a male shaft and a female shaft. Compared with a rotating connection mechanism in a conventional technology, a quantity of parts is greatly reduced. In addition, the damping pin relates to a cold heading process and a finish machining process, and there are few machining processes and machining operations. In addition, when the damping pin is connected to a component, a few assembly parts are used, or even no assembly part is required. In conclusion, the cabinet provided in embodiments of this application may effectively reduce a quantity of parts and a quantity of assembly parts, reduce assembly workload and assembly space, improve assembly efficiency, and reduce costs. Furthermore, the damping pin is small in size. When a span of a rotating connection part changes, one, two, or more damping pins may be disposed based on a specific working condition, without changing specifications of the damping pins, facilitating unification of product specifications. In addition, the damping pin is further editable in terms of a damping force. Generally, the damping pins are used in pairs. When the span of the rotating connection part is large, one or more damping pins may be added between two damping pins. Damping forces of a plurality of damping pins may be different. During assembly, different damping effect may be implemented through permutations and combinations of the damping pins.

### BRIEF DESCRIPTION OF DRAWINGS

FIG. 1 is a schematic diagram of a structure of a hinge;
FIG. 2 is a diagram of an application scenario of the hinge provided in FIG. 1;
FIG. 3 is a schematic diagram of an exploded structure of the hinge provided in FIG. 1;
FIG. 4 is a schematic diagram of a structure of a cabinet according to an embodiment of this application;
FIG. 5 is a schematic diagram of an exploded structure of the cabinet provided in FIG. 4;
FIG. 6 is a schematic diagram of a structure of a damping pin according to an embodiment of this application;
FIG. 7 is a schematic diagram of a cross-sectional structure of the damping pin provided in FIG. 6;
FIG. 8 is a cross-sectional view of a damping pin after being assembled with a first mounting base and a second mounting base according to an embodiment of this application;
FIG. 9 is an explanation diagram of editability of a damping force of a damping pin according to an embodiment of this application;
FIG. 10 is a schematic diagram of an exploded structure of a damping pin according to an embodiment of this application;
FIG. 11 is a schematic diagram of a cross-sectional structure of FIG. 10;
FIG. 12 is a schematic diagram of assembly of a damping pin assembled on a first mounting base and a second mounting base according to an embodiment of this application; and
FIG. 13 is a diagram of an appearance of a damping pin according to an embodiment of this application.

### Descriptions of reference numerals:

1: hinge; 2: bottom plate; 3: first vertical plate;
4: second vertical plate; 5: pivot shaft; 6: first through hole;
7: second through hole; 8: first positioning hole; 9: second positioning hole;
10: cabinet; 11: cabinet body; 12: door plate;
200: cabinet; 20: housing; 21: first mounting base;
30: cover plate; 31: second mounting base; 40: damping pin;
41: male shaft; 411: large head end; 412: pin;
4121: blind hole; 4122: groove; 42: female shaft;
421: jack; 4211: first limiting boss; 422: second limiting boss;
43: annular spring plate; 44: sealing cover; 45: knurling pattern.

### DESCRIPTION OF EMBODIMENTS

Terms used in implementations of this application are merely used to explain specific embodiments of this application, but are not intended to limit this application. The following describes implementations of embodiments of this application in detail with reference to the accompanying drawings.

A hinge is the most commonly used rotating connection mechanism. The hinge, also known as a joint, is a mechanical apparatus that connects two solids and allows the two solids to rotate relative to each other. The hinge may be made up of movable components or of foldable materials. The hinge is generally used for doors, windows, or cupboards. It provides a buffer function when a cupboard door is closed, minimizing noise generated by a collision with a cupboard when the cupboard door is closed. Alternatively, the cupboard door remains in a same position when being opened, so that a user easily obtains an object from the cupboard or avoids being pinched by the cupboard door.

However, an existing hinge structure generally features a complex structure, high manufacturing costs, inflexible rotation, a short service life, and the like. In addition, the hinge structure cannot be used for a long time in an outdoor environment, and is not applicable to, for example, being mounted to a cabinet or a module structure outdoors or at a high altitude in a network communication relay link. Therefore, improvement on the foregoing problems becomes an urgent problem to be resolved.

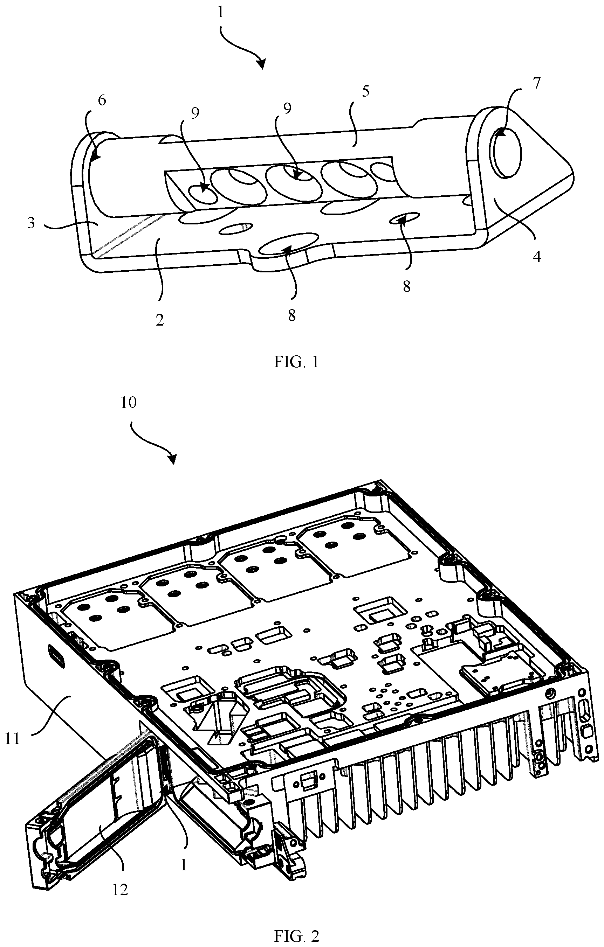

FIG. 1 is a schematic diagram of a structure of a hinge. Refer to FIG. 1. The hinge 1 includes a bottom plate 2, a first vertical plate 3, a second vertical plate 4, and a pivot shaft 5. The first vertical plate 3 and the second vertical plate 4 are disposed at two ends of the bottom plate 2. The first vertical plate 3 and the second vertical plate 4 are separately integrally molded with the bottom plate 2. The first vertical plate 3 is provided with a first through hole 6, and the second vertical plate 4 is provided with a second through hole 7. Two ends of the pivot shaft 5 are respectively rotatably disposed in the first through hole 6 and the second through hole 7. The bottom plate 2 is provided with a first positioning hole 8, and the pivot shaft 5 is provided with a second positioning hole 9. The first positioning hole 8 is configured to connect the hinge 1 to an object, and the second positioning hole 9 is configured to connect a door to the hinge 1.

FIG. 2 is a diagram of an application scenario of the hinge provided in FIG. 1. The hinge 1 may be used in a cabinet 10. With reference to FIG. 1 and FIG. 2, the cabinet 10 includes: a cabinet body 11, a door plate 12, and the hinge 1 shown in FIG. 1. The hinge 1 is securely connected to the cabinet body 11 through the first positioning hole 8 by using six fasteners, and is securely connected to the door plate 12 through the second positioning hole 9 by using five fasteners, to implement rotation between the door plate 12 and the cabinet body 11. In addition, the hinge 1 has damping effect, and a position of the hinge 1 may remain unchanged when the door plate 12 is opened.

Although the hinge 1 shown in FIG. 1 is improved based on a traditional hinge, there are still a series of problems.

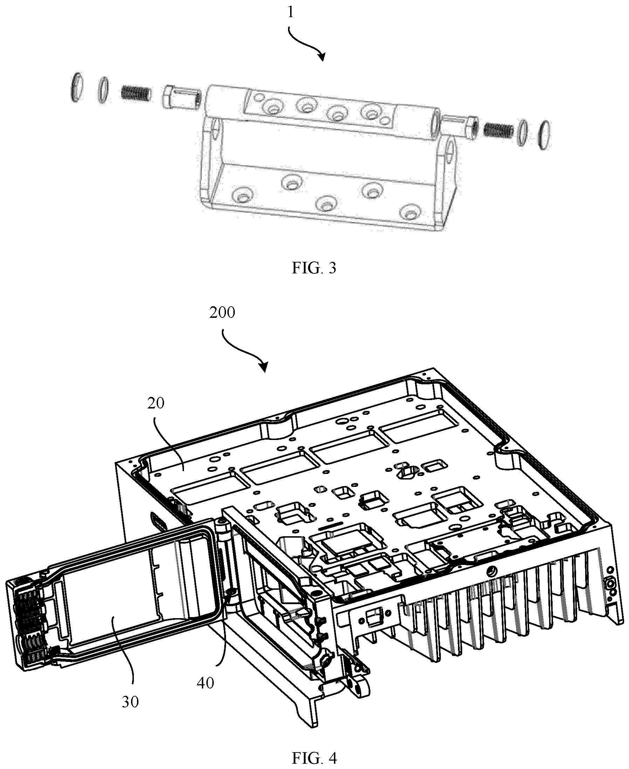

For example, FIG. 3 is a schematic diagram of an exploded structure of the hinge provided in FIG. 1. Refer to FIG. 3. The hinge 1 shown in FIG. 1 includes 10 core components and a large quantity of parts. Related processes include: a sheet metal process, a finish machining process, a cold heading process, an injection molding process, a die cutting process, and the like, and a plurality of machining processes are included.

For another example, the hinge 1 needs to use six fasteners to connect the hinge 1 to the cabinet body 11 through the first positioning hole 8, and then use five fasteners to connect the door plate 12 to the hinge 1 through the second positioning hole 9. During assembly, 11 fasteners are to be used, and corresponding holes are to be added through finish machining on the cabinet body 11 and the door plate 12. A plurality of parts are needed and an assembly process is complex, leading to low assembly efficiency and further leading to high costs.

In addition, because a length of the bottom plate 2 in the hinge 1 is fixed, when a width of a rotating joint between the door plate 12 and the cabinet body 11 changes, specifications of the hinge 1 change accordingly. Therefore, the hinge 1 shown in FIG. 1 is only appropriate for span-fixed-distance assembly. When a span changes, a hinge 1 of different specifications is to be used, resulting in low unification of product specifications.

To resolve the foregoing problem, embodiments of this application provide a cabinet and a damping pin. The damping pin includes two core components: a male shaft and a female shaft, and relates to a small quantity of processes and parts. In addition, when the damping pin is used in the cabinet, no assembly part is to be used. Therefore, assembly efficiency may be improved, and costs may be reduced. In addition, the damping pin may be applicable to various working conditions with different spans and different damping forces. This helps improve unification of product specifications.

The following describes in detail embodiments provided in this application with reference to the accompanying drawings.

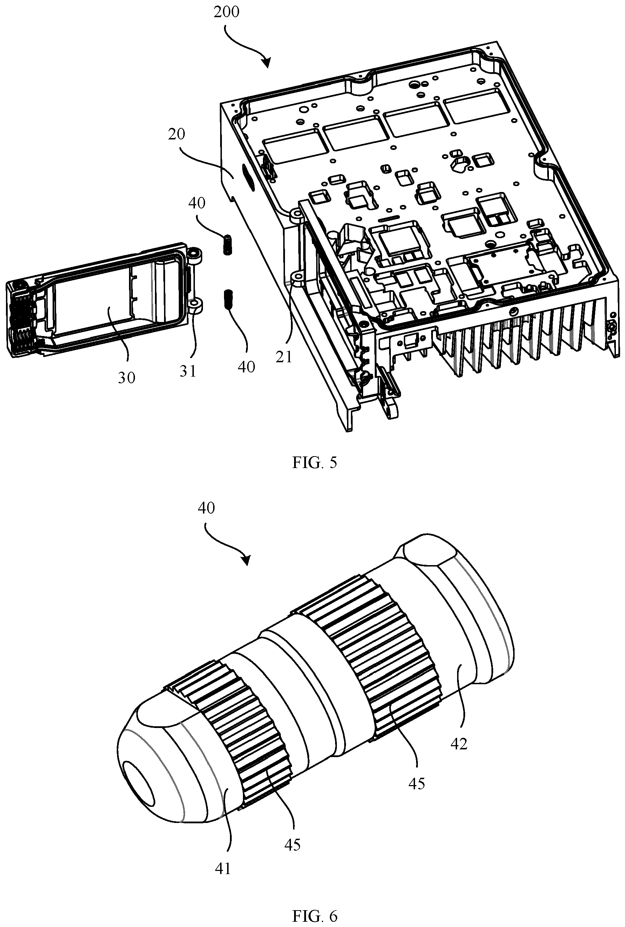

FIG. 4 is a schematic diagram of a structure of a cabinet 200 according to an embodiment of this application. FIG. 5 is a schematic diagram of an exploded structure of the cabinet 200 provided in FIG. 4. Refer to FIG. 4 and FIG. 5. The cabinet 200 provided in this embodiment of this application includes: a housing 20, a cover plate 30 that is rotatably disposed with the housing 20, and at least one damping pin 40. For example, in this embodiment, there are two damping pins 40.

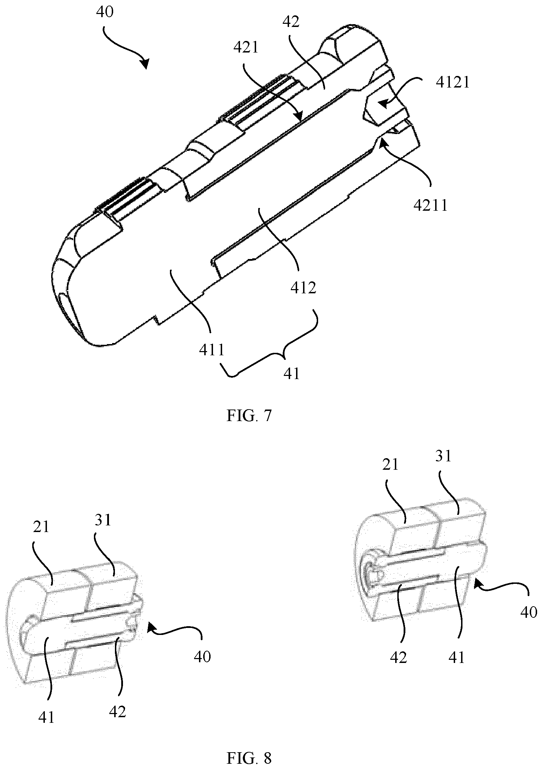

FIG. 6 is a schematic diagram of a structure of a damping pin 40 according to an embodiment of this application. FIG. 7 is a schematic diagram of a cross-sectional structure of the damping pin 40 provided in FIG. 6. Refer to FIG. 6 and FIG. 7. This embodiment of this application provides the damping pin 40. The damping pin 40 may be used as a rotating connection mechanism between objects, and includes a male shaft 41 and a female shaft 42.

The male shaft 41 includes a large head end 411 and a pin 412 connected to an end face of an end of the large head end 411. The female shaft 42 has a jack 421, the pin 412 is rotatably disposed in the jack 421, and at least a part of an outer side wall of the pin 412 is in an interference fit with an inner side wall of the jack 421. Damping effect of the damping pin 40 may be achieved through the interference fit between the outer side wall of the pin 412 and the inner side wall of the jack 421. In addition, a damping force may be adjusted by adjusting an interference amount between the outer side wall of the pin 412 and the inner side wall of the jack 421, a fit length of the pin 412 and the jack 421, and a size of an outer cylinder of the pin 412, to meet requirements of various working conditions.

FIG. 8 is a cross-sectional view of a damping pin 40 after being assembled with a first mounting base 21 and a second mounting base 31 according to an embodiment of this application. As shown in FIG. 5 and FIG. 8, the housing 20 has the first mounting base 21, and the cover plate 30 has the second mounting base 31. For example, in the accompanying drawings of this application, both the first mounting base 21 and the second mounting base 31 have mounting holes. The damping pin 40 passes through a mounting hole, so that one of the large head end 411 of the damping pin 40 and the female shaft 42 of the damping pin 40 is fastened in the first mounting base 21, and the other of the large head end 411 of the damping pin 40 and the female shaft 42 of the damping pin 40 is fastened in the second mounting base 31. In this embodiment of this application, an example in which the large head end 411 is fastened in the first mounting base 21 and the female shaft 42 is fastened in the second mounting base 31 is used for description. Certainly, in another embodiment of this application, the large head end 411 may be assembled in the second mounting base 31, and the female shaft 42 may be installed in the first mounting base 21.

After the assembly is completed, the cover plate 30 is rotated, and the second mounting base 31 drives the female shaft 42 to rotate. Because the first mounting base 21 is located on the housing 20, the first mounting base 21 keeps the large head end 411 still. In this way, a rotating connection between the cover plate 30 and the housing 20 may be implemented. In addition, due to the damping force of the damping pin 40, after the cover plate 30 is opened, a position of the cover plate 30 may remain unchanged. This facilitates maintenance of the cabinet 200 by an operator, and provides an anti-pinch function, ensuring safety of the operator. Common application scenarios include outdoor modules, cabinets, and the like. For operators working at heights, this may release their hands.

It should be understood that the damping pin 40 provided in embodiments of this application includes two core components: the male shaft 41 and the female shaft 42. Compared with a rotating connection mechanism in a conventional technology, a quantity of parts is greatly reduced. In addition, the damping pin 40 provided in embodiments of this application relates to a cold heading process and a finish machining process, and there are few machining processes and machining operations. In addition, when the damping pin 40 provided in embodiments of this application is connected to a component, a few assembly parts are used, or even no assembly part is required. In conclusion, the damping pin 40 provided in embodiments of this application may effectively reduce a quantity of parts and a quantity of assembly parts, reduce assembly workload and assembly space, improve assembly efficiency, and reduce costs. Furthermore, the damping pin 40 provided in embodiments of this application is small in size. When a span of a rotating connection part changes, one, two, or more damping pins 40 may be disposed based on a specific working condition, without changing specifications of the damping pins 40, facilitating unification of product specifications.

In addition, the damping pin 40 provided in embodiments of this application is further editable in terms of a damping force. Generally, the damping pins 40 are used in pairs. When the span of the rotating connection part is large, one or more damping pins 40 may be added between two damping pins 40. Damping forces of a plurality of damping pins 40 may be different. During assembly, different damping effect may be implemented through permutations and combinations of the damping pins.

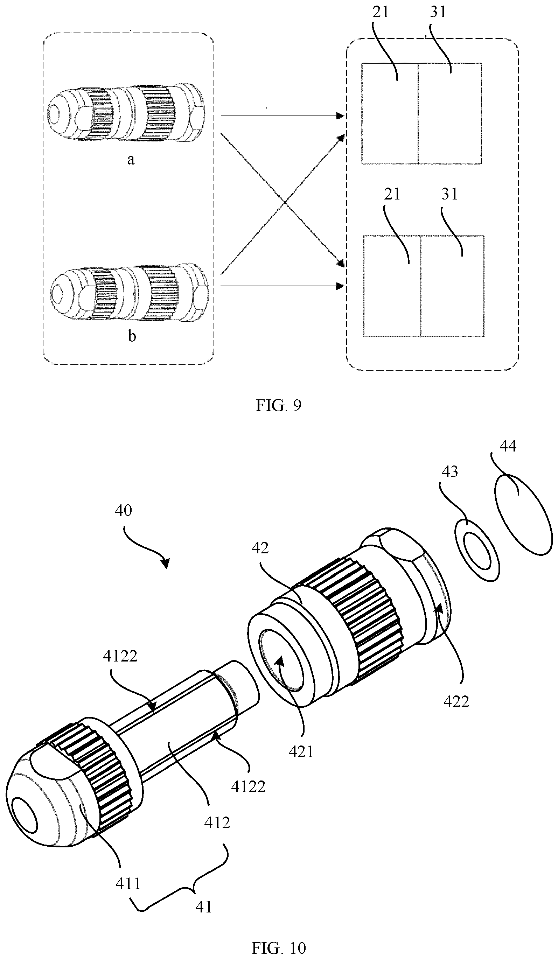

For example, FIG. 9 is an explanation diagram of editability of a damping force of a damping pin 40 according to an embodiment of this application. Refer to FIG. 9. Two types of damping pins 40 and two assembly positions are used as an example for description. In FIG. 9, the two types of damping pins 40 respectively have a damping force a and a damping force b, where a is not equal to b. The damping pins 40 are assembled in the first mounting base 21 and the second mounting base 31. Through combination, three different types of damping effect with total damping forces of a+a, a+b, and b+b may be implemented. In addition, because the two types of damping pins 40 exist independently, the two types of damping pins 40 are not limited by spacing between the two assembly positions.

For another example, two types of damping pins 40 and three assembly positions are used as an example for description. The two types of damping pins 40 respectively have a damping force a and a damping force b, where a is not equal to b. Through combination, four different types of damping effect with total damping forces of a+a+a, a+a+b, a+b+b, and b+b+b may be implemented.

It should be noted that, in this embodiment of this application, that the first mounting base 21 is disposed on the housing 20, and that the second mounting base 31 is disposed on the cover plate 30 is merely an example. Certainly, the damping pin 40 may be directly connected to the housing 20 and the cover plate 30. For example, the large head end 411 and the female shaft 42 of the damping pin 40 may be respectively connected to the housing 20 and the cover plate 30 through welding, clamping, bonding, or another commonly seen connection manner. A connection manner between the damping pin 40 and each of the housing 20 and the cover plate 30 is not limited herein, provided that the large head end 411 and the female shaft 42 of the damping pin 40 are respectively connected to one of the housing 20 and the cover plate 30, so that the large head end 411 and the female shaft 42 can rotate relative to each other.

It may be understood that, the damping pin 40 provided in embodiments of this application is not limited to being used in open positioning of the cover plate 30 during maintenance of the outdoor cabinet 200 or a module in the communication field. As a simplified rotation damping system, the damping pin 40 may be applied to a plurality of fields in which a rotation damping system is designed, for example, household, toys, or the like, by changing a size of the damping pin 40 and flexibly combining parts of various forms.

Certainly, this application is not limited thereto. Refer to FIG. 7. In some embodiments of this application, the first limiting boss 4211 may be disposed on the inner side wall of the jack 421, and the first limiting boss 4211 is clamped with the pin 412 to limit displacement of the pin 412 in an axial direction of the jack 421. For example, refer to FIG. 7. An end that is of the pin 412 and that is away from the large head end 411 may be clamped with the first limiting boss 4211, to prevent the male shaft 41 and the female shaft 42 from loosening and falling off during use, and ensure structural stability of the damping pin 40.

Still refer to FIG. 7. As an implementation of clamping the pin 412 and the first limiting boss 4211, a blind hole 4121 may be provided at an end that is of the pin 412 and that is away from the large head end 411. In this case, the jack 421 may be a through hole provided in the female shaft 42. After the pin 412 is inserted into the jack 421, a spin riveting swaging process is performed on the blind hole 4121 at an end that is of the jack 421 and that is away from the large head end 411, to enable an outer diameter of the pin 412 corresponding to the blind hole 4121 to be greater than an inner diameter of the first limiting boss 4211, so that an outer side wall of the blind hole 4121 is clamped with the first limiting boss 4211. This prevents the male shaft 41 and the female shaft 42 from loosening and falling off during use, and ensures structural stability of the damping pin 40.

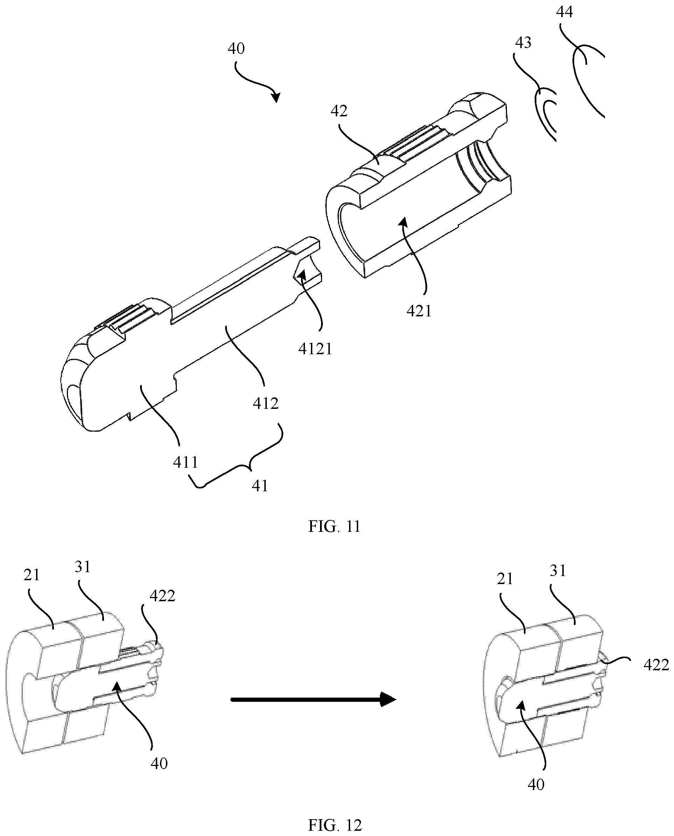

FIG. 10 is a schematic diagram of an exploded structure of a damping pin 40 according to an embodiment of this application. FIG. 11 is a schematic diagram of a cross-sectional structure of FIG. 10. Refer to FIG. 10 and FIG. 11. In some embodiments of this application, the damping pin 40 may further include an annular spring plate 43, where the annular spring plate 43 is configured to be sleeved on the outer side wall of the blind hole 4121, and an outer peripheral wall of the annular spring plate 43 is in an interference fit with the inner side wall of the jack 421. An interference amount of the annular spring plate 43 and the jack 421 may be adjusted to assist in adjusting a damping force.

Still refer to FIG. 10 and FIG. 11. In some embodiments of this application, the damping pin 40 may further include a sealing cover 44. The sealing cover 44 caps the end that is of the jack 421 and that is away from the large head end 411, and has dustproof, sealing, waterproof, and decoration functions, so that the damping pin 40 is applicable to a plurality of working conditions such as an outdoor working condition.

Refer to FIG. 10. In some embodiments of this application, a groove 4122 may be further provided on the outer side wall of the pin 412. The groove 4122 is configured to store an auxiliary medium, for example, damping paste, to reduce heat generated when the male shaft 41 and the female shaft 42 rotate relative to each other, reduce wear, and improve a service life of the damping pin 40.

The groove 4122 may be a straight groove parallel to the pin 412 in an axial direction in FIG. 10, or may be an annular groove perpendicular to the pin 412 in an axial direction, or may be a spiral groove on the outer side wall of the pin 412, or the like. A quantity and a shape of the groove 4122 are not limited herein.

Still refer to FIG. 10. In some embodiments of this application, an end that is of the large head end 411 of the damping pin 40 and that is away from the pin 412 is in a shape of a guide curved surface, to provide a guiding function for the damping pin 40 to be installed in the first mounting base 21 and the second mounting base 31. A second limiting boss 422 may be further disposed on an outer side wall that is of the female shaft 42 and that is away from the large head end 411, and the second limiting boss 422 plays a stop role after the damping pin 40 is installed on the first mounting base 21 and the second mounting base 31.

For an assembly manner of the damping pin 40, refer to FIG. 12. FIG. 12 is a schematic diagram of assembly of a damping pin 40 assembled on a first mounting base 21 and a second mounting base 31 according to an embodiment of this application. The assembly manner of the damping pin 40 is unidirectional insertion. After the mounting holes of the first mounting base 21 and the second mounting base 31 overlap, the large head end 411 with a guide curved surface of the damping pin 40 is first inserted from a side of the second mounting base 31, until the second limiting boss 422 and the second mounting base 31 stop.

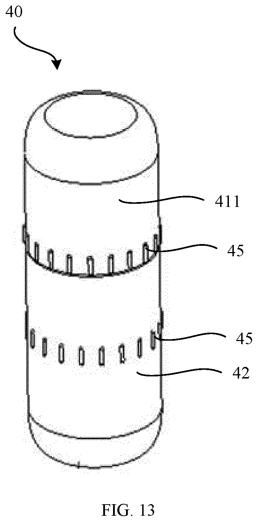

Certainly, the assembly manner of the damping pin 40 may alternatively be bidirectional insertion. In this case, an appearance of the damping pin 40 is shown in FIG. 13. FIG. 13 is a diagram of an appearance of a damping pin 40 according to an embodiment of this application. As shown in FIG. 13, both the end that is of the large head end 411 of the damping pin 40 and that is away from the pin 412 and an end that is of the female shaft 42 and that is away from the large head end 411 are in shapes of guide curved surfaces, and are generally similar to a shape of a capsule. The end that is of the female shaft 42 and that is away from the large head end 411 no longer has the second limiting boss 422, and other features are the same as those of the damping pin 40 described above. An end of the damping pin 40 may be fastened in the first mounting base 21, and then the other end of the damping pin 40 is fastened in the second mounting base 31.

Still refer to FIG. 6 and FIG. 13. In embodiments of this application, a manner in which the damping pin 40 is fastened in the first mounting base 21 and the second mounting base 31 may be as follows: A knurling pattern 45 is separately provided on an outer peripheral surface of the large head end 411 and an outer peripheral surface of the female shaft 42, and the knurling pattern 45 on the large head end 411 and the knurling pattern 45 on the female shaft 42 are respectively riveted and fitted with inner side walls of the mounting holes of the first mounting base 21 and the second mounting base 31. In this way, the damping pin 40 is fastened to the first mounting base 21 and the second mounting base 31. In this case, it should be ensured that a riveting torsion resistance force of the knurling pattern 45 and a corresponding assembly area is greater than a matching damping force of the pin 412 and the jack 421, so that the cover plate 30 does not shake after assembly. It may be understood that, an assembly manner of riveting the knurling pattern 45 into the mounting holes of the first mounting base 21 and the second mounting base 31 may make the assembly simple and easy to implement, and broaden application scenarios, effectively reducing assembly and disassembling space, and reducing finish machining of threaded holes required for screw assembly.

It should be noted that, for a fastened manner between the damping pin 40 and the first mounting base 21 and the second mounting base 31, the damping pin 40, the first mounting base 21, and the second mounting base 31 may alternatively be in a form of an abnormal cross section. For example, an overall appearance of the damping pin 40 may be set as a column, and the mounting holes of the first mounting base 21 and the second mounting base 31 may be designed as rectangular holes. The damping pin 40 with a rectangular cross section is inserted into the rectangular mounting holes to complete assembly of the damping pin 40 with the first mounting base 21 and the second mounting base 31.

In conclusion, in this application, methods of function subdivision and high decoupling are used to extract a core component that bears rotation damping effect, and allow the core component to exist in a form of the damping pin. To some extent, avoiding impact of factors such as a damping force, assembly spacing, an assembly manner, and the like on the rotating connection mechanism greatly improves assembly flexibility, reduces assembly difficulty, reduces assembly space and costs, and enhances product form normalization.

Advantages of the damping pin provided in embodiments of this application may be mainly summarized in three aspects.
1. A traditional rotating connection mechanism has a plurality of assembly parts and machining operations. Both types of machining processes and a quantity of parts of the damping pin provided in this application are reduced by 50%. This greatly reduces types of parts and machining operations, reduces a weight of a damping part, improves assembly efficiency, and facilitates manufacturing of an automated device.
2. The traditional rotating connection mechanism has a complicated assembly process in which finish machining of 11 hole positions are included, and screws, pins, and other parts are used for matching assembly. The damping pin provided in this application is assembled in an insertion and riveting manner, and does not include a positioning pin or an assembly screw, so that assembly efficiency of a damping system may be effectively improved, and an assembly time may be reduced by more than 60%.
3. Type selection of the traditional rotating connection mechanism is limited by a span and damping of the traditional rotating connection mechanism, and the traditional rotating connection mechanism is not compatible with requirements of different spans. The damping pins provided in this application are used in pairs, and may be compatible with a plurality of spans. In addition, a plurality of combined damping forces may be implemented by combining damping pins with different damping forces, so that a product normalization level may be effectively improved.

The foregoing descriptions are merely specific implementations of this application, but are not intended to limit a protection range of this application. Any variation or replacement readily figured out by persons skilled in the art within the technical range disclosed in this application should fall within the protection range of this application. Therefore, the protection scope of this application shall be subject to the protection scope of the claims.

In descriptions of embodiments of this application, it should be noted that, unless otherwise clearly specified and limited, the terms "installation", "connection to", and "connection" should be understood in a broad sense. For example, the connection may be a fastened connection, may be an indirect connection by using an intermediate medium, or may be an internal connection between two elements or an interaction relationship between two elements. For persons of ordinary skill in the art, specific meanings of the foregoing terms in embodiments of this application may be understood based on a specific situation.

An apparatus or an element in embodiments of this application or an implied apparatus or element needs to have a specific direction and be constructed and operated in a specific direction, and therefore cannot be construed as a limitation to embodiments of this application. In the descriptions of embodiments of this application, "a plurality of" means two or more, unless otherwise precisely and specifically specified.

In the specification, claims, and accompanying drawings of embodiments of this application, the terms "first", "second", "third", "fourth", and so on (if existent) are intended to distinguish between similar objects but do not necessarily indicate a specific order or sequence. It should be understood that data used in such a way is interchangeable in a proper circumstance, so that embodiments of this application described herein, for example, can be implemented in other orders than the order illustrated or described herein. Moreover, the terms "include", "contain" and any variant thereof are intended to cover a non-exclusive inclusion. For example, a process, method, system, product, or device that includes a list of steps or units is not necessarily limited to those steps or units that are expressly listed, but may include other steps or units not expressly listed or are inherent to the process, method, product, or device.

Finally, it should be noted that, the foregoing embodiments are merely intended for describing the technical solutions of embodiments of this application other than limiting embodiments of this application. Although embodiments of this application are described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of embodiments of this application.

## Claims

1. A damping pin, comprising a male shaft and a female shaft, wherein
the male shaft comprises: a large head end and a pin connected to an end face of an end of the large head end; and
the female shaft has a jack, the pin is rotatably disposed in the jack, and at least a part of an outer side wall of the pin is in an interference fit with an inner side wall of the jack.

2. The damping pin according to claim 1, wherein the inner side wall of the jack has a first limiting boss; and
the first limiting boss is clamped with the pin to limit displacement of the pin in an axial direction of the jack.

3. The damping pin according to claim 2, wherein an end that is of the pin and that is away from the large head end has a blind hole; and
an outer side wall of the blind hole is enabled, by the blind hole through a spin riveting swaging process, to clamp with the first limiting boss.

4. The damping pin according to claim 3, further comprising an annular spring plate, wherein
the annular spring plate is sleeved on the outer side wall of the blind hole, and an outer peripheral wall of the annular spring plate is in an interference fit with the inner side wall of the jack.

5. The damping pin according to any one of claims 1 to 4, further comprising a sealing cover, wherein
the sealing cover caps an end that is of the jack and that is away from the large head end.

6. The damping pin according to any one of claims 1 to 5, wherein a groove is provided on the outer side wall of the pin; and
the groove is configured to store an auxiliary medium.

7. The damping pin according to any one of claims 1 to 6, wherein an end that is of the large head end and that is away from the pin is in a shape of a guide curved surface.

8. The damping pin according to claim 7, wherein a second limiting boss is disposed on an outer side wall that is of the female shaft and that is away from the large head end.

9. The damping pin according to any one of claims 1 to 8, wherein both the end that is of the large head end and that is away from the pin and an end that is of the female shaft and that is away from the large head end are in shapes of guide curved surfaces.

10. The damping pin according to any one of claims 1 to 9, wherein knurling patterns are provided on an outer peripheral surface of the large head end and an outer peripheral surface of the female shaft.

11. A cabinet, comprising: a housing, a cover plate that is rotatably disposed with the housing, and at least one damping pin according to any one of claims 1 to 10, wherein
the housing has a first mounting base, and the cover plate has a second mounting base; and
one of the large head end of the damping pin and the female shaft of the damping pin is fastened in the first mounting base, and the other of the large head end of the damping pin and the female shaft of the damping pin is fastened in the second mounting base.
